# EUROPEAN PATENT APPLICATION

(11) **EP 1 255 293 A1**
(43) Date of publication of application: **06.11.2002**
(21) Application number: 00985938.0
(22) Date of filing: 27.12.2000
(51) Int. Cl.: H01L 21/60

(54) **METHOD AND DEVICE FOR CHIP MOUNTING**

(30) Priority: 14.01.2000 JP 2000006560
(71) Applicant: TORAY ENGINEERING CO., LTD., Osaka-shi, Osaka 530-0005 (JP)
(72) Inventor: YAMAUCHI, Akira Toray Engineering Co., Ltd., Otsu-shi, Shiga 520-2141 (JP)
(74) Representative: Weber, Joachim, Dr.
(86) International application number: JP0009307
(87) International publication number: WO01052317

(57) **Abstract**

A method and a device for chip mounting; the method comprising the steps of forming an elastic or plastic bump (22) on a chip (2), providing an adhesive (24) to a substrate (20) beforehand, moving the chip (2) near the substrate (20) to press the bump (22) against an electrode (23) on the substrate (20), expanding the adhesive (24) between the chip (2) and the substrate (20), controlling the height of a head when the bump (22) is pressed against the electrode (23), and allowing non-uniform pressing condition between the bump (22) and the electrode (23) to be absorbed by the elastic or plastic deformation of the bump (22), whereby a variation in dimensions of the substrate can be absorbed properly, the height of the head can be controlled quickly, and a bonding time can be shortened remarkably and, when a bonding process is divided into a preliminary bonding process and a main bonding process, a preliminary bonding process time can be shortened remarkably, and an actual tact time in an entire chip bonding process can be shortened remarkably.

## Description

### Technical Field of the Invention

The present invention relates to a method and a device for chip mounting, specifically to a method and a device for chip mounting which can properly absorb a variation in dimensions of a substrate and the like when a chip is mounted to the substrate and which can greatly shorten the mounting time.

### Background Art of the Invention

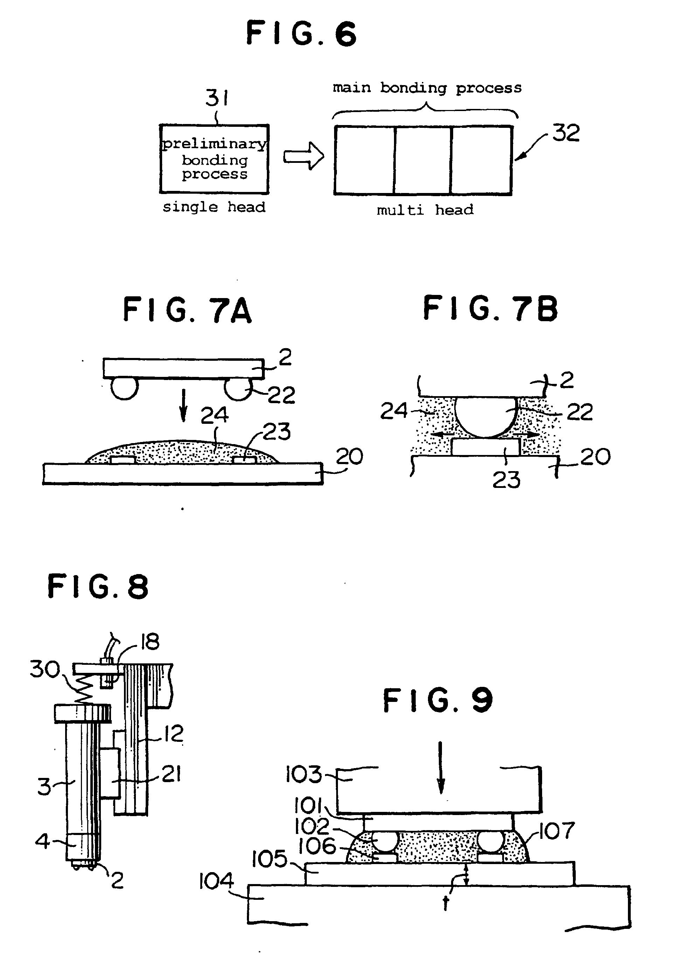

Many methods for chip mounting have been proposed. For example, as shown in Fig. 9, a method is known wherein a chip 101 formed with bumps 102 is held by a head 103 of a bonding tool by suction and the like, bumps 102 of chip 101 are pressed to electrodes 106 of a substrate 105 (a circuit board or a liquid crystal board) by approaching the chip 101 to the substrate 105 supported by a bonding stage 104, and bumps 102 and electrodes 106 are bonded to each other by heating them by a heater (not shown) provided in the head 103 of the bonding tool. In this chip mounting, also known is a method for interposing or injecting an adhesive 107 (for example, an underfill agent, a conductive paste or a conductive film, an insulating paste or an insulating film, and further, a flux for a solder bump and the like) between chip 101 and substrate 105.

On the other hand, also known is a two-stage mounting method for preliminarily bonding chip 101 and substrate 105 by pressing bumps 102 to electrodes 106 of the substrate 105 and adhering via adhesive 107, and thereafter, performing a main bonding by heating and melting bumps 102 and curing the adhesive. This method is carried out in order to shorten the tact time of the entire chip bonding process by, for example, performing the main bonding using a multi-head system relative to one preliminary bonding device, because a time required for the main bonding is fairly longer than a time required for the preliminary bonding.

In such conventional methods, however, there remain the following problems. As shown in Fig. 9, in substrate 105, there occurs a variation in the positions of electrodes 106 of substrate 105 supported by stage 104, particularly, a variation in the height direction, by a variation in dimensions originating from a variation of the thickness (t), the bowing and the like. Further, if there is an undulation on stage 104, similarly there occurs a positional variation in the height direction of electrodes 106 of substrate 105 supported by the stage 104. On the other hand, as to the side of chip 101, although head 103 is moved down to press bumps 102, if there is the above-described variation in dimensions in the side of substrate 105, substantially it becomes difficult to control the height of head 103 at a high accuracy. Further, if the accuracy of the height of head 103 being controlled is improved as much as possible by detecting the contact between bumps 102 and the substrate side, the moving down speed of the head 103 must be reduced, and it becomes difficult to shorten the time of this chip bonding process. Furthermore, if the moving down speed of head 103 is increased, an impact occurs when bumps 102 come into contact with electrodes 106, and an inconvenience such as deformation or damage may be generated in both the chip side and the substrate side. Further, if controlled with a contact pressure, because a chip may be broken by an impact ascribed to a high speed, the speed must be reduced. From such circumstances, actually it is difficult to control the height of head 103, and it is difficult to increase the moving down speed of the head 103, ultimately, to shorten the time of the process.

Further, as aforementioned, in a case where the process is divided into a preliminary bonding process and a main bonding process, it is possible to shorten the tact time of the entire chip bonding process by forming the device for the main bonding process as a multi-head device. However, from the above-described reasons, because it is difficult to greatly shorten the actual preliminary bonding process time, even if the chip bonding process is divided into such processes, the effect for shortening the entire tact time is limited.

### Disclosure of the Invention

Accordingly, a first object of the present invention is to remarkably shorten a bonding time of a chip and a substrate by absorbing a dimensional variation of the substrate side naturally and properly and controlling the height of a head holding the chip quickly.

Further, a second object of the present invention, in a case where a chip bonding process is divided into a preliminary bonding process and a main bonding process, is to remarkably shorten the time of the preliminary bonding process, thereby increasing the effect of the divided processes, and to remarkably shorten an actual tact time of the entire chip bonding process.

To accomplish the above objects, a chip bonding method according to the present invention comprises the steps of forming an elastic or plastic bump on at least one of a chip and a substrate, forming an electrode on the other, providing an adhesive to the substrate beforehand, moving the chip near the substrate to press the bump against the electrode, expanding the adhesive between the chip and the substrate, controlling the height of a head holding the chip when the bump is pressed against the electrode, and allowing non-uniform pressing condition between the bump and the electrode to be absorbed by the elastic or plastic deformation of the bump. Namely, the method enables the chip to be mounted at a high speed in a desired condition, substantially only by control of the height of the head.

In the present invention, the elastic or plastic bump is formed on at least one of the chip and the substrate. Namely, there are (A) a case where the elastic or plastic bump is formed on the chip and the electrode is formed on the substrate, (B) a case where the elastic or plastic bump is formed on the substrate and the electrode is formed on the chip, and (C) a case where the elastic or plastic bump is formed on each of the chip and the substrate. Therefore, particularly in the case of (C), the "electrode" according to the present invention means a technical concept including a bump.

In the present invention, as the method for providing the adhesive to the substrate beforehand, can be employed any of a method for applying an adhesive agent onto the substrate by a dispenser or by printing or transfer and the like, and a method for applying an adhesive film onto the substrate. The adhesive provided beforehand is expanded between the chip and the substrate when the chip is approached to the substrate, and particularly, after the bump is brought into contact with the electrode, the adhesive is expanded around the bump and the electrode in contact with each other. The bonding therebetween can be achieved more surely by firstly bringing the bump into contact with the electrode. In order to achieve this condition, it is preferred to apply the adhesive agent partially onto the substrate beforehand (in a case of an adhesive film, to apply the adhesive film partially onto the substrate beforehand), and particularly, to apply it between the electrodes of the substrate so as not to cover each electrode.

However, the adhesive agent or the adhesive film may be applied over the entire surface of the substrate beforehand. In this case, although the bump and the electrode cannot be brought into contact with each other in advance, for example, by forming the bump in a shape of a convex and pressing the bump to the electrode at a pressure capable of allowing the bump to be deformed elastically or plastically, it is possible to push away the adhesive agent or the adhesive film having existed on the electrode to around the bump and substantially to achieve a close contact between the bump and the electrode.

Further, if the adhesive is expanded up to the side portion of the chip by further pushing the chip toward the substrate after the above-described pressing, the bonding strength and the retaining strength of the chip relative to the substrate can be increased. Especially, if the chip is pressed so as that a fillet can be formed on the side portion of the chip by the expanded adhesive, because the chip can be bonded by the formed fillet in addition to the adhesive present between the chip and the substrate, the bonding strength and the retaining strength of the chip can be further increased. Moreover, since the bonding portion of the bump and the electrode can be surely sealed from the surrounding environment by the formed fillet, it becomes possible to increase the electrical insulation property and the like.

As the above-described elastic or plastic bump, a solder bump or a polymer bump formed by a conductive paste and the like is preferred. In a solder bump, as long as heated at a temperature higher than a predetermined temperature, the state thereof becomes elastic or plastic by softening or melting, and therefore, it is possible to use such a bump by employing an adequate condition. The solder bump employed in the present invention includes, of course, a bump using a solder composed of lead and tin, and includes a bump using a solder composed of a metal except them, and includes all solders capable of being melt bonded at a metallic phase. The polymer bump employed in the present invention is a bump capable of retaining silver flake-like conductive materials in a contact condition, filling the gaps thereof with a polymer (a resin), and always being maintained as an electric conductive body while being deformed elastically. Such a polymer bump can be formed, for example, by using a metal mask as a stencil and screen printing a conductive paste and the like. Furthermore, as a bump according to the present invention, a resin such as a conductive plastic can also be used.

Particularly, in the present invention, it is preferred to use an elastic bump. By using such a bump, non-uniform pressing condition between the bump and the electrode can be absorbed by the elastic deformation of the bump when the bump is pressed to the electrode, and at the same time, the adhesive can be expanded around the bump and the electrode in contact with each other so as to prevent the adhesive from entering into a portion between the bump and the electrode pressed to each other. Further, during the bump is pressed to the electrode, a proper pressing condition between the bump and the electrode can be maintained by the elastic force of the bump so as to prevent the adhesive from entering into a portion between the bump and the electrode. In particular, even if a variation of the distance between the chip and the substrate occurs (for example, even in a case where the chip is slightly lifted between the preliminary bonding process and the main bonding process as described later), the variation can be absorbed and a proper pressing condition can be maintained so that the adhesive does not enter into a portion between the bump and the electrode.

Further, in the present invention, it is preferred that an undulation of a stage supporting the substrate is stored in memory beforehand, and the height of the head is controlled for each chip mounting position. In such a control, even in a case where there is a small undulation on the stage, the height of the head can be controlled accurately for each chip mounting position, and each bump can surely exhibit an excellent function as described above.

In the chip mounting method according to the present invention, as described above, the process can be divided into a preliminary bonding process and a main bonding process so that the chip and the substrate are preliminarily bonded by the pressing of the bump to the electrode and the adhesion by the adhesive expanded between the chip and the substrate, and thereafter the bump and the electrode are bonded mainly. Where, it can be possible to use an adhesive having a property shrinking at the time of curing and perform the pressing of the bump to the electrode and the expanding of the adhesive as the preliminary bonding process, and in the main bonding process, the adhesive can be cured by using a heating furnace or/and an ultra-violet ray irradiation furnace. By using such an adhesive having a shrinkage property at the time of curing, even if the chip is slightly lifted between the preliminary bonding process and the main bonding process, the position of the chip can be returned to the original position by the shrinkage of the adhesive, and in that state, the main bonding process can be carried out in a re-flow furnace. Moreover, because a shrinking force operates at the time of curing of the adhesive and the shrinking force operates in the same direction as that in which the chip is pressed to the substrate side by the head, the chip pressing force due to the head can be released at a timing that the curing has progressed to some extent, and as compared with a case where the pressing force is continued to be added, it becomes possible to shorten the tact time and increase the productivity.

A chip mounting device according to the present invention comprises a head for holding a chip formed with an elastic or plastic bump or an electrode and capable of controlling at least its height, a stage for supporting a substrate formed with an electrode or an elastic or plastic bump and applied with an adhesive beforehand, and a mechanism for escaping the head in a direction opposite to a pressing direction (in an upward direction) in a case where a reactive force more than a predetermined pressure is generated when the chip is pressed to the substrate. Even in a case where there occurs a missetting of the substrate or its thickness varies more than a predetermined value, when the bump is pressed to the electrode, the reactive force operates to the head holding the chip and an upward force is applied to the head moving down, and when a reactive force more than a predetermined pressure is applied, the head is escaped upward, whereby a proper pressing force can be kept and a breakage of the chip, the substrate or the head can be prevented.

The chip mounting device can be constructed as a device comprising a preliminary bonding device portion having the above-described head for the preliminary bonding of the chip and the substrate and a main bonding device portion having bonding means by heating or/and ultra-violet ray irradiation. In this device, it is preferred that the main bonding device portion has bonding means by heating or/and ultra-violet ray irradiation more in number than those of the head in the preliminary bonding device portion.

In the above-described chip mounting method and device according to the present invention, when the head is moved down and the bump is brought into contact with the electrode, the height of the head is properly controlled, and the bump is deformed elastically or plastically by an adequate amount. Therefore, even if the head is moved down at a high speed and the bump is brought into contact with the electrode at a relatively high speed, because the bump elastically or plastically deforms naturally and properly, an impact does not occur, and besides, even if there is a dimensional variation in the substrate side, it can be absorbed by the elastic or plastic deformation of the bump. Namely, a desired pressing condition can be achieved quickly, and as the control therefor, substantially only the control of the height of the head holding the chip may be carried out. Therefore, the time required for achieving a desired pressing condition can be shortened remarkably, thereby increasing the productivity greatly.

As the result of shortening the time required for achieving a desired pressing condition between the bump and the electrode remarkably as described above, in a case where the process is divided into a preliminary bonding process until the time of the pressing and a following main bonding process, even if the main bonding process requires a relatively long time, as aforementioned, by obtaining the effect of the greatly shortened preliminary bonding process time while performing the main bonding process by a multi-head system, the time required for treating a predetermined amount as the whole of the chip bonding process can be greatly shortened. As a result, the tact time of the entire chip bonding process can be actually shortened remarkably, and the productivity can be increased extremely.

### Brief explanation of the drawings

Figure 1 is a schematic view of a chip mounting device according to an embodiment of the present invention.
Figure 2 is a schematic side view showing a state before chip mounting in a chip mounting method according to an embodiment of the present invention.
Figure 3 is a schematic vertical sectional view showing a state bringing a bump into contact with an electrode of a substrate.
Figure 4 is a schematic vertical sectional view showing a state bringing a bump into contact with an electrode while elastically deforming the bump.
Figure 5 is a schematic vertical sectional view showing a state further pushing a chip from the state shown in Fig. 4.
Figure 6 is a schematic view showing an example of a case divided into a preliminary bonding process and a main bonding process.
Figures 7A and 7B are schematic views showing a pressing process in a case of applying an adhesive on the entire surface of a substrate.
Figure 8 is a schematic view showing a modification of a mechanism for escaping a pressure more than a predetermined value in the device shown in Fig. 1.
Figure 9 is a schematic view showing a conventional pressing process.

### The Best mode for carrying out the Invention

Hereinafter, desirable embodiments of the present invention will be explained referring to figures.

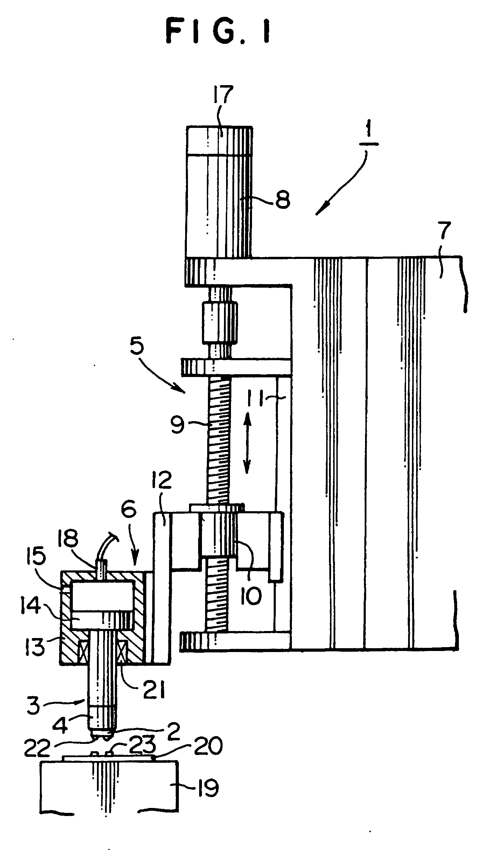

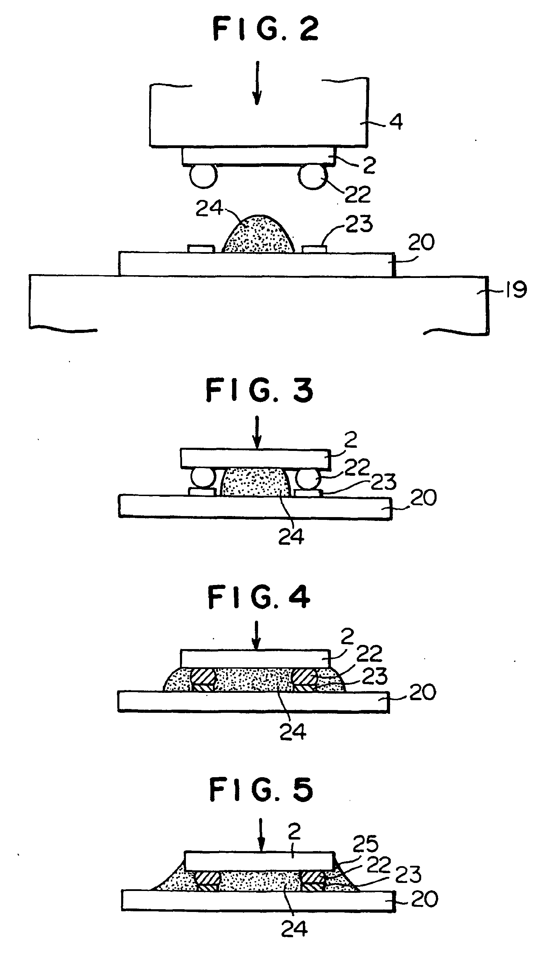

Fig. 1 shows a chip mounting device according to an embodiment of the present invention, and shows a case where elastic or plastic bumps are formed on the chip side and electrodes are formed on the substrate side. Fig. 2 shows a state immediately before chip mounting when a chip mounting method according to the present invention is carried out using the device. In Fig. 1, a chip mounting device 1 has a head 4 of a bonding tool 3 which holds a chip 2 (for example, an IC chip) by suction. In this embodiment, the bonding tool 3 comprises a height control device 5 for controlling a schematic height, which is moved up and down in the vertical direction, and a mechanism 6 for escaping a pressure more than a predetermined pressure, which comprises an air cylinder mechanism or a spring mechanism, and the bonding tool 3 is positionally controlled in the vertical direction.

Height control device 5 rotates a ball screw 9 by a servo motor 8 attached to a device frame 7, and moves a ball screw slider 10 engaged with the ball screw 9 up and down guiding it along a rail 11 fixed to the device frame 7. Mechanism 6 for escaping a pressure more than a predetermined pressure is connected to ball screw slider 10 of height control device 5 via a bracket 12. This pressure escaping mechanism 6 is constructed as an air cylinder mechanism having an air cylinder tube 13 and a piston 14 inserted thereinto, and bonding tool 3 and head 4 thereof are connected to the lower side of the piston 14 which is guided only in the vertical linear direction while regulated in the rotational direction by a vertical linear bearing 21. A pressurizing port 15 is opened on air cylinder tube 13, and although the head 4 is pressed downward by the pressurized air supplied through the port 15, the head 4 can be escaped upward when an undesirable pressure more than a predetermined pressure (a reactive force) is applied to the head 4.

The position in the vertical direction controlled by height control device 5 is detected by, for example, an encoder 17 equipped to servo motor 8, and a sensor 18 for detecting a condition that an undesirable pressure more than a predetermined pressure is applied is provided, for example, on the top portion of air cylinder tube 13.

Under chip 2, a substrate 20 (for example, a circuit board or a liquid crystal board) is supported and fixed by suction and the like at a predetermined position on a bonding stage 19. Bonding tool 3 is constructed so as to be regulated in the rotational direction by vertical linear bearing 21 and guided only in the vertical linear direction.

Because mechanism 6 for escaping a pressure more than a predetermined pressure is constructed as an air cylinder mechanism, when a certain reactive force more than a predetermined value is applied from the side of chip 2 held by head 4 toward the upper direction, piston 14 and bonding tool 3 connected thereto can escape upward.

Although mechanism 6 for escaping a pressure more than a predetermined pressure is constructed as an air cylinder mechanism in the above-described embodiment, as a modification is shown in Fig. 8, for example, it may be constructed as a mechanism wherein a spring 30 is provided on the upper portion of bonding tool 3 and the bonding tool 3 is regulated in the rotational direction by vertical linear bearing 21 and guided only in the vertical linear direction. when a certain reactive force more than a predetermined value is applied from the side of chip 2 held by head 4 toward the upper direction, the spring 30 can absorb the pressure more than the predetermined value.

As shown in Fig. 2, in the above-described embodiment, elastic bumps 22 are formed on chip 2. The bump 22 is formed, for example, as a polymer bump formed by a conductive paste. Electrodes 23 (for example, gold plated electrodes) are formed on substrate 20, and bumps 22 and electrodes 23 are pressed to each other at a condition where the positions of electrodes 23 and the positions of the corresponding bumps 22 of chip 2 are conformed with each other.

Prior to this pressing, an adhesive 24 is provided by application onto substrate 20 beforehand. Adhesive 24 is selected depending upon the bonding process, and selected from a conductive paste, an insulation paste, an underfill agent, a flux and the like. In this embodiment, the adhesive 24 is applied on substrate 20 at a position between electrodes 23 so as not to cover each electrode 23 and so as to slightly protrude. However, as described later, it is possible to apply adhesive 24 substantially over the entire surface of substrate 20.

From the state shown in Fig. 2, bonding tool 3 is moved down, chip 2 is approached to substrate 20, and bumps 22 are brought into contact with electrodes 23 of the substrate as shown in Fig. 3. At that time, adhesive 24 having been applied is pressed between chip 2 and substrate 20 and expanded therebetween. In this embodiment, firstly bumps 22 come into contact with electrodes 23 of the substrate, and thereafter, chip 2 is further pushed down, whereby adhesive 24 is further pressed to expand up to the side portion of the chip 2, as shown in Fig. 4. In this state, bump 22 elastically deforms by a certain amount, and adhesive 24 is filled around the bump 22 and the electrode 23 pressed to each other.

In order to reach this state, in this embodiment, substantially only the height of chip 2 (the vertical position) is controlled relative to the position of substrate 20. More concretely, in this embodiment, in order to achieve the above-described state, only the height control of chip 2 by height control device 5 is carried out.

In a case where there occurs a variation in thickness or a bowing in substrate 20, the height of the substrate 20 supported on stage 19, particularly, the positions of the upper surfaces of electrodes 23 may also vary. However, when bumps 22 are pressed to electrodes 23, because the bumps 22 elastically deform naturally and properly, such a dimensional variation can be absorbed with no problem. Further, even in a case where there is an undulation on stage 19, by detecting the undulation beforehand and storing it in memory, it becomes possible to amend the height of head 4 to be controlled in accordance with each mounting position of chip 2, and the dimensional variation ascribed to the undulation can be absorbed with no problem.

Further, even in a case where bump 22 is pressed to electrode 23 at a high speed, because the elastically deformed bump 22 can absorb an impact smoothly and naturally, the impact does not occur actually. As a result, a high-speed pressing of bump 22 and electrode 23 becomes possible, and the time required for this pressing process can be decreased remarkably. Furthermore, although it has been necessary to press a head until the curing of an adhesive in a conventional case using, for example, a plastic bump, in the present invention, because bump 22 elastically deforms as described above, even if head is moved away after pressing, chip 2 and substrate 20 are in a condition where the viscosity of the adhesive and the elastic restoring force of bump 22 are balanced, and the bump 22 and the electrode 23 can be prevented from being separated from each other by the elastic restoring force of bump 22, or the adhesive can be prevented from entering into therebetween. Therefore, even in a case where the process is divided into a preliminary bonding process and a main bonding process as described later, a fear, that there occurs a problem between the preliminary bonding process and the main bonding process, is removed, and by dividing the process into the preliminary bonding process and the main bonding process, the tact time of the entire bonding process can be shortened. In particular, if an adhesive having a shrinking property at the time of curing is used, when the adhesive is cured in the main bonding process, for example, using a heating furnace or/and an ultra-violet ray irradiation furnace, even if the chip has been slightly lifted between the preliminary bonding process and the main bonding process, the position of the chip can be returned to its original position by the shrinkage of the adhesive, and at such a state, the main bonding can be carried out in a reflow furnace. Moreover, by utilizing the shrinking force of the adhesive, the pressing force of chip 2 by head 4 can be released at a stage that the curing has progressed to some extent, and as compared with a case where the pressing force is continued to be applied, the tact time can be further shortened and the productivity can be further increased.

Further, since adhesive 24 is applied onto substrate 20 beforehand and it is expanded together with the pressing in this embodiment, it is not necessary to inject an adhesive into a fine gap between chip 2 and substrate 20 at a following timing, and therefore, also from this point of view, the time required for the entire pressing and bonding process can be greatly shortened and the process can be simplified. In this embodiment, because bump 22 is composed of an elastic bump, in addition to the above-described absorption of a variation in pressing state, the adhesive can be extended around the bump 22 and the electrode 23 in a good condition so that the adhesive does not enter between the bump 22 and the electrode 23. After bump 22 is pressed onto electrode 23, a proper pressing condition between the bump 22 and the electrode 23 can be maintained by the elastic force of the bump 22 so that the adhesive does not enter between the bump 22 and the electrode 23. Especially, even in a case where chip 2 is slightly lifted between the preliminary bonding process and the main bonding process, the proper pressing condition can be maintained by the elastic restoring force of the bump 22 so that the adhesive does not enter between the bump 22 and the electrode 23.

Furthermore, by setting the initial application amount of adhesive 24 and the amount for the aforementioned height control at proper amounts, as shown in Fig. 4, the adhesive 24 can be extended over the entire required area between chip 2 and substrate 20, and desired adhesion condition, adhesion strength and seal condition from the surrounding environment can be achieved.

In this embodiment, as shown in Fig. 5, chip 2 is further pressed toward the side of substrate 20 from the state shown in Fig. 4. This further pressing can also be controlled height control device 5.

When further pressed as shown in Fig. 5, adhesive 24 having been interposed between chip 2 and substrate 20 is further pressed and expanded up to the side portion of the chip 2, and for example, the adhesive 24 is expanded so that a fillet 25 is formed at the side portion of the chip 2 by the expanded adhesive 24. As compared with a case of no fillet, by the formation of the fillet 25, chip 2 can be adhered to and retained by substrate 20 more strongly. Further, because the pressed bonding portions between bumps 22 and electrodes 23 are sealed from the surrounding environment more completely, the reliability in electrical insulation property can also be further increased. In this condition, although bump 22 is elastically deformed more greatly, there is no problem with respect to a bump having a large allowance for elastic deformation such as a polymer bump.

In the above-described pressing process of bump 22, it is possible to provide a heater (not shown) in head portion 4 of bonding tool 3 and carry out a process up to the main bonding of bump 22 and electrode 23 by heating after the pressing or substantially simultaneously with the progress of the pressing.

However, generally there is a great difference in time required for process between the preliminary bonding by pressing and the main bonding by heating and melting (the time for the main bonding is fairly longer). Therefore, if a preliminary bonding process and a main bonding process are carried out as separated processes and the main bonding is carried out by a multi-head system relative to the preliminary bonding, it becomes possible to shorten the tact time of the entire bonding process. As aforementioned, in a case where the time required for the preliminary bonding process is not so short, a remarkable advantage cannot be expected even if such a system is employed. However, in the present invention, as the result that the time for the required pressing of the bump (that is, the time required for the preliminary bonding process) can be remarkably shortened, the time for the entire bonding process can be greatly shortened by employing the dividing system into the preliminary bonding and the main bonding. Further, as aforementioned, if an adhesive having a shrinking property at the time of curing is used, because it becomes possible to release the pressing of the head in a early stage at the time of the main bonding, the time for the main bonding itself can also be shortened, and the time for the entire bonding process can be further shortened.

In order to realize such a shortening of time, for example, as shown in Fig. 6, the device may be constructed as a chip mounting device combining a preliminary bonding device portion 31 having a single head and a main bonding device portion 32 having a plurality of heads more in number (that is, a multi-head system). A most efficient process can be achieved by substantially balancing the total time for preliminarily bonding a plurality of chips in order in the preliminary bonding device portion 31 and the time for mainly bonding all the preliminarily bonded chips simultaneously in the main bonding device portion 32, thereby shortening the time of the entire bonding process remarkably. Further, in the present invention, since the time for the preliminary bonding can be remarkably shortened, the number of heads in the main bonding device portion 32 can be greatly increased. Therefore, when a certain amount of chip bonding is carried out, the constitution of the entire bonding device can be easily formed as a constitution capable of shortening the time required for the entire bonding process remarkably.

Furthermore, although the position for application of an adhesive to be applied beforehand is set at a partial portion between electrodes on the substrate in the aforementioned embodiment, it is possible to apply the adhesive substantially over the entire surface of the substrate. For example, as shown in Fig. 7A, adhesive 24 is applied on substrate 20 so as to cover electrodes 23, and in this state, chip 2 is moved down and pressed. At that time, as shown in Fig. 7B, when bump 22 comes into contact with electrode 23, because adhesive 24 having been present on the electrode 23 is pushed toward around the contact portion, the bump 22 and the electrode 23 can be brought into close contact with each other in a good condition by setting a proper height of the bump 23 moved down. Particularly, because bump 22 is elastic, a better close contact can be achieved by pressing the bump 22 onto the electrode 23 so that the bump 22 is elastically deformed slightly.

Although the above-described embodiment has been explained mainly with respect to a elastic bump (for example, a polymer bump), even in a case of a plastic bump, an operation and an effect similar to those described above can be obtained. Further, even in a case where an adhesive film is applied instead of an adhesive agent, similar operation and effect can be obtained.

Further, in the present invention, the formation of chip 2 is not particularly restricted, and as long as an elastic or plastic bump is formed, the present invention can be applied effectively to any type of chip. Further, also the formation of substrate 20 is not particularly restricted, and the present invention can be applied to any type of substrate to which a chip having the above-described bump is mounted.

Furthermore, in the present invention, although a bump and an electrode are bonded by heating at the time of a main bonding, there is a case where metal bonding cannot be carried out depending upon the material of the electrode. Even in such a case, if an elastic polymer bump is employed, because the bump and an electrode can be always brought into contact with each other without forming a gap therebetween even if an adhesive expands by heat or moisture, a good electrical connection can be maintained.

Although embodiments forming an elastic or plastic bump on the chip side have been explained hereinabove, in the present invention, the position for forming the elastic or plastic bump is not limited to the chip side, and it may be formed on the substrate side or may be formed on each of the chip side and the substrate side. In a case where the bump is formed on each of the chip side and the substrate side, as aforementioned, the "electrode" in the present invention means a technical concept including an elastic or plastic bump.

### Industrial Applications of the Invention

In the chip mounting method and device according to the present invention, only by controlling the height of a chip moved down, the chip can be quickly bonded to a substrate at a desired pressing condition without generating an impact while absorbing a dimensional variation of the substrate naturally and smoothly, the time for achieving a desired pressing condition can be shortened remarkably, and the productivity can be increased greatly. The present invention is suitable for a process in which a large number of chips are continuously bonded to substrates, and especially, by dividing the bonding process into a preliminary bonding process and a main bonding process, the tact time of the entire process can be remarkably shortened, and the productivity can be increased extremely. The present invention can be applied to any type of bonding process requiring such shortening of tact time and increase of productivity without limiting the kinds of chip and substrate.

## Claims

1. A method for mounting a chip comprising the steps of forming an elastic or plastic bump on at least one of a chip and a substrate, forming an electrode on the other, providing an adhesive to the substrate beforehand, moving the chip near the substrate to press the bump against the electrode, expanding the adhesive between the chip and the substrate, controlling the height of a head holding the chip when the bump is pressed against the electrode, and allowing non-uniform pressing condition between the bump and the electrode to be absorbed by the elastic or plastic deformation of the bump.

2. The chip mounting method according to claim 1, wherein said adhesive is provided to said substrate by applying an adhesive agent or an adhesive film onto the substrate beforehand, and when said chip is moved near the substrate, said adhesive is expanded around said bump and said electrode after the bump is brought into contact with the electrode.

3. The chip mounting method according to claim 1, wherein said bump is an elastic bump, and when the bump is pressed to said electrode, non-uniform pressing condition between the bump and the electrode is absorbed by the elastic deformation of the bump and said adhesive is expanded around the bump and the electrode, and during the bump is being pressed to the electrode, the variation of a distance between the chip and the substrate is absorbed while the pressing condition is maintained, by the elastic force of the bump.

4. The chip mounting method according to claim 1, wherein an undulation of a stage supporting said substrate is stored in memory beforehand, and the height of said head is controlled for each chip mounting position.

5. The chip mounting method according to claim 1, wherein an adhesive having a property shrinking at the time of curing is used as said adhesive, the pressing of said bump to said electrode and the expanding of the adhesive are carried out as a preliminary bonding process, and in a main bonding process for curing the adhesive, a heating furnace or/and an ultra-violet ray irradiation furnace is used.

6. A device for mounting a chip comprising:
a head for holding a chip formed with an elastic or plastic bump or an electrode and capable of controlling at least its height;
a stage for supporting a substrate formed with an electrode or an elastic or plastic bump and applied with an adhesive beforehand; and
a mechanism for escaping said head in a direction opposite to a pressing direction in a case where a reactive force more than a predetermined pressure is generated when said chip is pressed to said substrate.

7. The chip mounting device according to claim 6, wherein the device comprises a preliminary bonding device portion having said head for the preliminary bonding of said chip and said substrate and a main bonding device portion having bonding means by heating or/and ultra-violet ray irradiation.

8. The chip mounting device according to claim 7, wherein said main bonding device portion has bonding means by heating or/and ultra-violet ray irradiation more in number than those of said head in said preliminary bonding device portion.
